# EUROPEAN PATENT APPLICATION

(11) **EP 4 804 350 A1**
(43) Date of publication of application: **09.09.2026**
(21) Application number: 25893270.6
(22) Date of filing: 16.09.2025
(51) Int. Cl.: H01S 5/183, H01S 5/42, H01S 5/042

(54) **VERTICAL-CAVITY SURFACE-EMITTING LASER ARRAY AND INTEGRATED SYSTEM**

(30) Priority: 16.01.2025 CN 202510071197
(71) Applicant: Vertilite Co., Ltd., Changzhou, Jiangsu 213167 (CN)
(72) Inventor: LIANG, Dong, Changzhou, Jiangsu 213167 (CN); DING, Wei-Zun, Changzhou, Jiangsu 213167 (CN); LIU, Song, Changzhou, Jiangsu 213167 (CN); WENG, Wei-Cheng, Changzhou, Jiangsu 213167 (CN)
(74) Representative: HGF
(86) International application number: PCT/CN2025/121509
(87) International publication number: WO 2026/152749

(57) **Abstract**

The present disclosure relates to a vertical-cavity surface-emitting laser array and an integrated system. The array includes at least one laser (1). The laser (1) includes a substrate (11) and at least one first unit (12) located above the substrate (11). The first unit (12) includes a laser emitting structure (121) and a connection structure (122) located above the laser emitting structure (121). The laser emitting structure (121) is provided with at least one light-emitting aperture (121a). The connection structure (122) at least includes a first electrode (122a) and an electrically conductive heat-spreading layer (122b), which are sequentially stacked. The first electrode (122a) is disposed opposite to the light-emitting aperture (121a). The electrically conductive heat-spreading layer (122b) covers the first electrode (122a). An orthographic projection of the light-emitting aperture (121a) on the substrate (11) is located within an orthographic projection of the electrically conductive heat-spreading layer (122b) on the substrate (11).

## Description

### CROSS-REFERENCE TO RELATED APPLICATIONS

This application claims priority to Chinese patent application No. 2025100711976, entitled "VERTICAL-CAVITY SURFACE-EMITTING LASER ARRAY AND INTEGRATED SYSTEM" filed on January 16, 2025, the content of which is hereby incorporated by reference in its entirety.

### TECHNICAL FIELD

The present disclosure relates to the technical field of semiconductors, and in particular to a vertical-cavity surface-emitting laser array and an integrated system.

### BACKGROUND

With the development of artificial intelligence, graphics processing units (GPUs) have posed increased requirements for interconnection bandwidth and transmission speed. Conventional pluggable devices are gradually unable to meet the input/output requirements of GPUs in terms of bandwidth density, information power consumption, and cost.

Currently, optoelectronic devices such as vertical-cavity surface-emitting lasers, silicon photonic laser transmitters, edge-emitting external cavity tunable lasers, and micro-light-emitting diode arrays are mainly adopted to address the above output issues. Among them, the GPU input/output solution based on vertical-cavity surface-emitting lasers is the most promising technology, as it combines single-channel bandwidth with two-dimensional integration, achieving optimal bandwidth density.

However, to achieve the advantages of the vertical-cavity surface-emitting laser, the distance between emitters needs to be small. The conventional approach uses metals to lead out electrodes, which protects the emitters, but requires a relatively large area and has a poor heat dissipation effect, reducing the stability of the packaged structure.

### SUMMARY

According to various embodiments of the present disclosure, a vertical-cavity surface-emitting laser array and an integrated system are provided.

According to various embodiments of the present disclosure, a vertical-cavity surface-emitting laser array is provided, including:
at least one laser, the laser including a substrate and at least one first unit located on the substrate; wherein the first unit includes a laser emitting structure and a connection structure located above the laser emitting structure; the laser emitting structure is provided with at least one light-emitting aperture; the connection structure at least includes a first electrode and an electrically conductive heat-spreading layer, which are sequentially stacked; the first electrode is disposed opposite to the light-emitting aperture; the electrically conductive heat-spreading layer covers the first electrode; and an orthographic projection of the light-emitting aperture on the substrate is located within an orthographic projection of the electrically conductive heat-spreading layer on the substrate.

In some embodiments, the laser emitting structure includes a confinement layer and a confinement trench extending through the confinement layer, and the confinement trench surrounds the light-emitting aperture; an orthographic projection of the confinement trench on the substrate is at least partially located within the orthographic projection of the electrically conductive heat-spreading layer on the substrate.

In some embodiments, the laser emitting structure further includes an insulating layer, and the insulating layer is filled in the confinement trench.

In some embodiments, the electrically conductive heat-spreading layer is further filled in the confinement trench.

In some embodiments, the laser emitting structure is provided with a plurality of the light-emitting apertures, and two adjacent light-emitting apertures share a confinement trench adjacent to the two adjacent light-emitting apertures.

In some embodiments, the confinement trench surrounding the light-emitting aperture includes a plurality of trenches spaced from each other.

In some embodiments, the confinement trench surrounding the light-emitting aperture includes an annular trench.

In some embodiments, the connection structure further includes a first electrically conductive pillar, and the first electrically conductive pillar is located on an upper surface of the electrically conductive heat-spreading layer.

In some embodiments, the laser further includes at least one second unit; the second unit is located on an upper surface of the substrate and is electrically connected to the first unit; the second unit at least includes a second electrode and a second electrically conductive pillar, and an upper surface of the second electrically conductive pillar is flush with an upper surface of the first electrically conductive pillar.

In some embodiments, the second unit further includes an electrically conductive pad, and the electrically conductive pad is located between the second electrically conductive pillar and the second electrode.

In some embodiments, the electrically conductive pad includes a first pad portion and a second pad portion, and the second pad portion and the electrically conductive heat-spreading layer are disposed in a same plane.

In some embodiments, the laser includes a plurality of the first units; the plurality of the first units share the second unit, and the plurality of the first units share the connection structure.

In some embodiments, the laser includes a plurality of the first units; the plurality of the first units share the second unit, or the plurality of the first units share the connection structure.

In some embodiments, the vertical-cavity surface-emitting laser array includes a plurality of the lasers; the first units in the plurality of lasers share the connection structure, and the first units in the plurality of lasers share the second unit.

In some embodiments, the vertical-cavity surface-emitting laser array includes a plurality of the lasers; the first units in the plurality of lasers share the connection structure, or the first units in the plurality of lasers share the second unit.

According to various embodiments of the present disclosure, an integrated system is also provided, including: the vertical-cavity surface-emitting laser array according to any of the above embodiments and a base board, wherein the vertical-cavity surface-emitting laser array is mounted on the base board and is electrically connected to the base board.

In some embodiments, the integrated system further includes a driving structure, a signal conversion structure, and a signal amplification structure; and the driving structure, the signal amplification structure, and the signal conversion structure are all electrically connected to the base board.

Details of one or more embodiments of the present disclosure are set forth in the accompanying drawings and the description below. Other features, objects, and advantages of the present disclosure will become apparent from the specification, the accompanying drawings, and the claims.

### BRIEF DESCRIPTION OF THE DRAWINGS

In order to illustrate the technical solutions in the embodiments of the present disclosure or in the conventional technology more clearly, the drawings used in the description of the embodiments or the conventional technology will be described briefly. Apparently, the following described drawings are merely for the embodiments of the present disclosure, and other drawings can be derived by those of ordinary skill in the art based on these drawings without any creative effort.
FIG. 1 is a schematic structural cross-sectional view of a vertical-cavity surface-emitting laser array provided in an embodiment.
FIG. 2 is a schematic structural cross-sectional view of another vertical-cavity surface-emitting laser array provided in an embodiment.
FIG. 3 is a schematic structural cross-sectional view of a third vertical-cavity surface-emitting laser array provided in an embodiment.
FIG. 4 is a schematic structural top view of an electrically conductive heat-spreading layer and a confinement trench provided in an embodiment.
FIG. 5 is a schematic structural top view of another electrically conductive heat-spreading layer and another confinement trench provided in an embodiment.
FIG. 6 is a schematic structural top view of a third electrically conductive heat-spreading layer and a third confinement trench provided in an embodiment.
FIG. 7 is a schematic structural view of an arrangement pattern of a vertical-cavity surface-emitting laser array provided in an embodiment.
FIG. 8 is a schematic structural view of another arrangement pattern of a vertical-cavity surface-emitting laser array provided in an embodiment.
FIG. 9 is a schematic structural view of a third arrangement pattern of a vertical-cavity surface-emitting laser array provided in an embodiment.
FIG. 10 is a schematic structural view of a fourth arrangement pattern of a vertical-cavity surface-emitting laser array provided in an embodiment.
FIG. 11 is a schematic structural view of a fifth arrangement pattern of a vertical-cavity surface-emitting laser array provided in an embodiment.
FIG. 12 is a schematic structural view of a sixth arrangement pattern of a vertical-cavity surface-emitting laser array provided in an embodiment.
FIG. 13 is a schematic structural view of an arrangement pattern in a laser provided in an embodiment.
FIG. 14 is a schematic structural view of another arrangement pattern in a laser provided in an embodiment.
FIG. 15 is a schematic structural view of a third arrangement pattern in a laser provided in an embodiment.
FIG. 16 is a schematic structural view of an integrated system provided in an embodiment.
FIG. 17 is a schematic structural view of another integrated system provided in an embodiment.
FIG. 18 is a schematic structural view of a third integrated system provided in an embodiment.

To better describe and illustrate the embodiments and/or examples of those inventions disclosed herein, reference can be made to one or more accompanying drawings. Additional details or examples used to describe the drawings should not be considered as limitations on the scope of any of the disclosed inventions, the presently described embodiments and/or examples, and the presently understood best mode of these inventions.

### DETAILED DESCRIPTION

In order to facilitate the understanding of the present disclosure, the present disclosure will be comprehensively described with reference to the drawings. Embodiments of the disclosure are shown in the drawings. However, the present disclosure can be implemented in many different ways and is not limited to the embodiments described herein. On the contrary, the purpose of providing these embodiments is to make the understanding of the present disclosure more thorough and comprehensive.

Unless otherwise defined, all technical and scientific terms used herein have the same meaning as commonly understood by those skilled in the technical field to which the present disclosure belongs. The terminology used herein in the description of the present disclosure is merely for the purpose of describing specific embodiments, and is not intended to limit the present disclosure.

It should be understood that when an element or layer is referred to as being "on", "adjacent to", "connected to" or "coupled to" another element or layer, it can be directly on, adjacent to, connected, or coupled to another element or layer, or intervening elements or layers can be present. In contrast, when an element is referred to as being "directly on", "directly adjacent to", "directly connected to", or "directly coupled to" another element or layer, there are no intervening elements or layers. It should be understood that although terms such as first, second, third, etc. can be used to describe various elements, components, regions, layers, doping types, and/or sections, these elements, components, regions, layers, doping types, and/or sections should not be limited by these terms. These terms are only used to distinguish one element, component, region, layer, doping type, or section from another element, component, region, layer, doping type, or section. Therefore, a first element, component, region, layer, doping type, or section discussed below can be termed a second element, component, region, layer, or section without departing from the teachings of the present disclosure.

Spatial relationship terms such as "under", "below", "lower", "beneath", "over", "upper", etc., can be used herein to describe the relationship of one element or feature to another element or feature as illustrated in the drawings. It should be understood that besides the orientations of the elements or features shown in the drawings, the spatial relationship terms are intended to encompass other different orientations of the device in use or operation. For example, if the device in the drawings is placed upside down, the elements or features described as "below", "beneath", or "under" other elements or features can then be oriented "over" the other elements or features. Thus, the exemplary terms "below" and "under" can encompass both an orientation of above and an orientation of below. In addition, the device can be otherwise oriented, e.g., rotated by 90 degrees or at other orientations, and the spatial descriptors used herein are interpreted accordingly.

As used herein, the singular forms with "a", "an", "the", or "said" can also encompass the plural forms, unless the context clearly indicates otherwise. It should also be understood that the terms "composed of" and/or "include" used in this specification identify the presence of stated features, integers, steps, operations, elements and/or components, but do not exclude the presence or addition of one or more other features, integers, steps, operations, elements, components, and/or groups. Meanwhile, as used herein, the term "and/or" encompasses any and all combinations of the associated listed items.

The related structures of the embodiments of the present disclosure should not be limited to the specific shapes of the structures shown in the accompanying drawings of the specification, but include shape deviations due to, for example, manufacturing techniques.

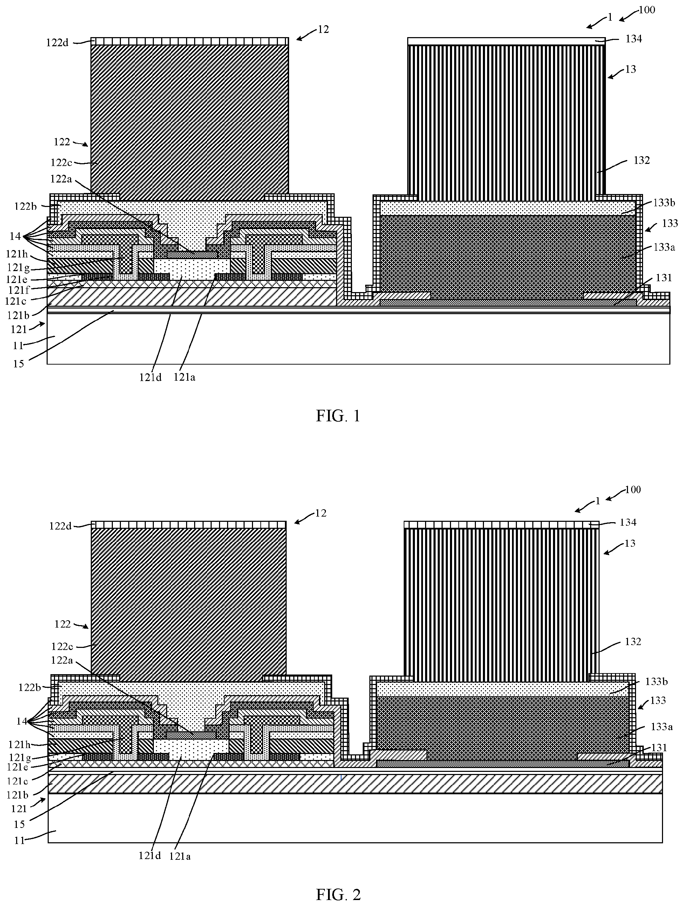

Referring to FIGS. 1 to 3, the present disclosure provides a vertical-cavity surface-emitting laser array 100 including at least one laser 1. The laser 1 includes a substrate 11 and at least one first unit 12 located on the substrate 11. The first unit 12 includes a laser emitting structure 121 and a connection structure 122 located above the laser emitting structure 121. The laser emitting structure 121 is provided with at least one light-emitting aperture 121a. The connection structure 122 at least includes a first electrode 122a and an electrically conductive heat-spreading layer 122b, which are sequentially stacked. The first electrode 122a is disposed opposite to the light-emitting aperture 121a. The electrically conductive heat-spreading layer 122b covers the first electrode 122a. An orthographic projection of the light-emitting aperture 121a on the substrate 11 is located within an orthographic projection of the electrically conductive heat-spreading layer 122b on the substrate 11.

According to the above-mentioned vertical-cavity surface-emitting laser array 100, the connection structure 122 is directly formed above the laser emitting structure 121 in the laser 1, the electrically conductive heat-spreading layer 122b of the connection structure 122 covers the first electrode 122a, and the orthographic projection of the light-emitting aperture 121a on the substrate 11 is located within the orthographic projection of the electrically conductive heat-spreading layer 122b on the substrate 11. Thus, the connection structure 122 located above the laser emitting structure 121 can fully meet the heat dissipation requirement during the operation of the laser emitting structure 121, thereby effectively improving the heat dissipation performance of the laser 1, and can effectively reduce the volume of the laser 1, thus realizing the fabrication of the device with a high bandwidth density. In some embodiments, the laser 1 is provided with at least one first unit 12 and at least one second unit 13. The upper surface of the first unit 12 is flush with the upper surface of the second unit 13. The upper parts of the first unit 12 and the second unit 13 severe as electrode input and output terminals, resulting in a same-side electrode layout, which makes the wiring more concise, reduces the complex layout requirements for electrode connections, and lowers the difficulty of the manufacturing process. Moreover, the same-side electrode design significantly shortens the distance between the anode and the cathode, thereby reducing parasitic resistance and capacitance, which is conducive to improving the operation speed and frequency response performance of the device. In addition, this structure also provides a higher design freedom for a multi-channel light-emitting array, enabling more convenient integration of the array and connection of the driving circuit, and improving the bandwidth density of the device. In some embodiments, by designing a plurality of lasers 1 in one vertical-cavity surface-emitting laser array 100 and designing a plurality of first units 12 in one laser 1, more light-emitting channels can be provided per unit area, thereby improving the bandwidth density, and making optical communication modules and consumer electronic product designs more compact while having improved bandwidth density.

The substrate 11 is configured to provide mechanical support for other structures of the laser 1, serving as a basis for subsequent epitaxial growth and device processing. Moreover, the substrate 11 is an electrically conductive substrate, which is configured to provide a current path for operation of the laser 1. The material of the substrate 11 includes gallium arsenide, indium phosphide, silicon, or other suitable materials. The size and shape of the substrate 11 can be selected according to actual conditions as long as the performance of the emitter is satisfied, and are not limited herein.

As shown in FIGS. 1 to 3, the laser emitting structure 121 further includes a first reflective layer 121b, an active layer 121c, and a second reflective layer 121d. The light-emitting aperture 121a is located between the second reflective layer 121d and the active layer 121c.

Exemplarily, the active layer 121c is made of a direct bandgap semiconductor material, which can efficiently convert injected carriers (i.e., electrons and holes) into photons. The material of the active layer 121c includes a gallium arsenide-based material, an indium phosphide-based material, a gallium nitride-based material, or other suitable materials. The active layer 121c adopts a single-layer or multi-layer quantum well structure, so as to optimize the photoelectric conversion efficiency. The active layer 121c is a core region for achieving stimulated emission, where injected electrons and holes recombine in the quantum well to release photons having a specific wavelength. The active layer 121c is located between the first reflective layer 121b and the second reflective layer 121d, thereby maximizing the overlap with the resonant cavity optical mode to improve the laser output efficiency.

Exemplarily, the first reflective layer 121b and the second reflective layer 121d are each composed of multiple alternating layers of high-refractive-index and low-refractive-index materials. The thickness of each layer is such that its optical thickness equals 1/4 of the design wavelength, so as to form multiple-beam interference satisfying the Bragg condition. The material of the first reflective layer 121b includes a gallium arsenide-based material, an indium phosphide-based material, titanium dioxide, silicon dioxide, or other suitable materials. The material of the second reflective layer 121d includes a gallium arsenide-based material, an indium phosphide-based material, titanium dioxide, silicon dioxide, or other suitable materials. The thickness of the second reflective layer 121d is in a range from 3 µm to 7 µm. In the present embodiment, the thickness of the second reflective layer 121d is 5 µm. The first reflective layer 121b and the second reflective layer 121d serve as high-reflectivity mirrors, forming a vertical resonant cavity together with the active layer 121c in the region of the light-emitting aperture 121a, reflecting the photons generated by the active layer 121c back and forth between the first reflective layer 121b and the second reflective layer 121d to produce a laser beam, thereby providing optical feedback for the laser emitting structure 121 while optimizing the laser performance. In the present embodiment, the first reflective layer 121b is an N-type distributed bragg reflector (N-DBR), and the second reflective layer 121d is a P-type distributed bragg reflector (P-DBR).

Exemplarily, electric current is injected into the active layer 121c through the light-emitting aperture 121a, and the light-emitting aperture 121a confines the injected electric current to a central region of the active layer 121c, which avoids lateral spreading of electric current, reducing parasitic electric current, improving utilization efficiency of electric current, thereby reducing the threshold current of the laser 1 and improving the electric current-optical power characteristics. By regulating the diameter of the light-emitting aperture 121a, miniaturization and high power density of the vertical-cavity surface-emitting laser can be achieved. On the premise of satisfying the performance of the vertical-cavity surface-emitting laser, the diameter of the light-emitting aperture 121a can be selected according to actual conditions, and is not limited herein.

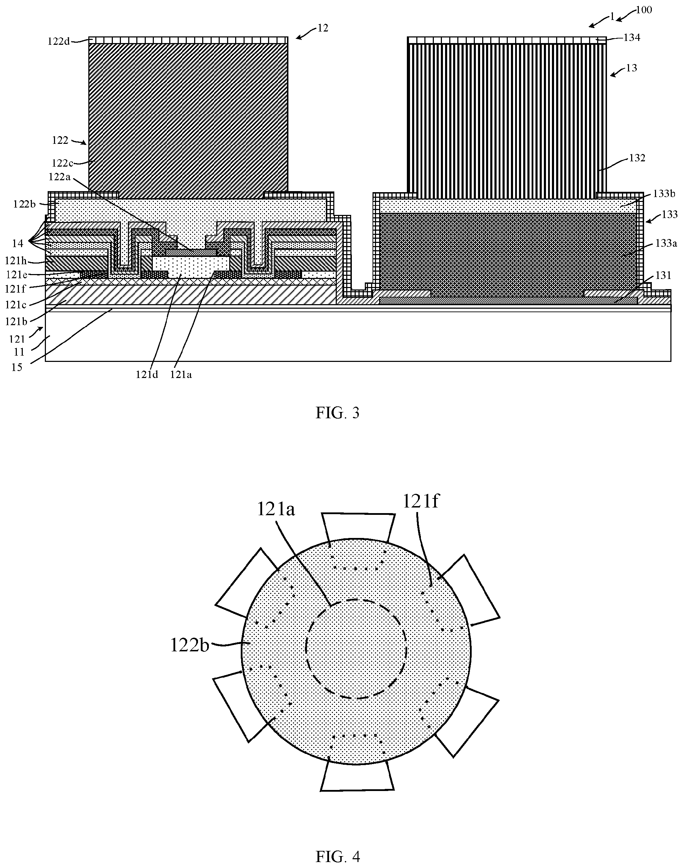

Exemplarily, as shown in FIGS. 4 to 6, the laser emitting structure 121 includes a confinement layer 121e and a confinement trench 121f extending through the confinement layer 121e. The confinement trench 121f surrounds the light-emitting aperture 121a. An orthographic projection of the confinement trench 121f on the substrate 11 is at least partially located within the orthographic projection of the electrically conductive heat-spreading layer 122b on the substrate 11. The material of the confinement layer 121e includes aluminum gallium arsenide with a high aluminum content, which is easily oxidized in a wet and oxygen-containing environment and can be converted into aluminum oxide to form an electrically insulative confinement layer 121e. The confinement layer 121e serves as an insulator, which allows electric current to pass through the region of the light-emitting aperture 121a only, and concentrates carriers and photons in the region of the light-emitting aperture 121a, thereby reducing unnecessary loss, improving electric current injection efficiency, lowering the threshold current, and improving the quantum efficiency of the laser. The confinement trench 121f can guide lateral electric current to the region of the light-emitting aperture 121a, thereby optimizing the vertical injection path of the electric current and reducing the lateral spreading of the electric current, thus reducing the parasitic electric current. On the premise of satisfying the performance of the vertical-cavity surface-emitting laser, the size of the confinement trench 121f can be selected according to actual conditions, and is not limited herein. A distance between the opposing sidewalls of the confinement trench 121f adjacent to the light-emitting aperture 121a is in a range from 10 µm to 15 µm. In the present embodiment, the distance between the opposing sidewalls of the confinement trench 121f adjacent to the light-emitting aperture 121a is 13 µm.

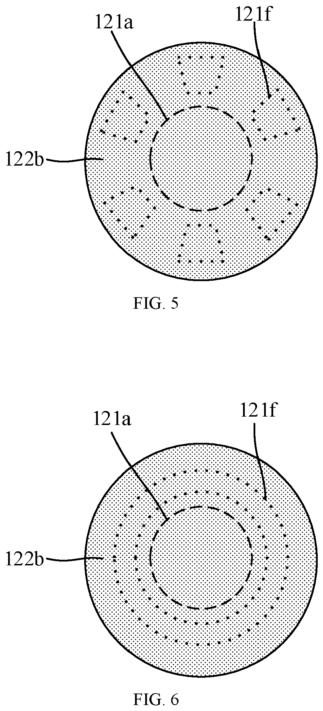

In some embodiments, as shown in FIGS. 4 and 5, the laser emitting structure includes a plurality of confinement trenches 121f arranged to surround the light-emitting aperture 121a, and the plurality of confinement trenches are spaced apart from each other. Exemplarily, the confinement trench 121f has a trapezoid shape or other suitable shapes.

In other embodiments, as shown in FIG. 6, the laser emitting structure includes an annular confinement trench 121f surrounding the light-emitting aperture 121a. By designing a suitable structure and shape of the confinement trench 121f, the lateral electric current can be effectively guided to the region of the light-emitting aperture 121a, thereby reducing the lateral spreading of the electric current and reducing parasitic capacitance.

In some embodiments, as shown in FIGS. 5 to 6, an orthographic projection of a side wall of the confinement trench 121f away from the light-emitting aperture 121a on the substrate is located within the orthographic projection of the electrically conductive heat-spreading layer 122b on the substrate. That is, the electrically conductive heat-spreading layer 122b fully covers the operation region of the laser emitting structure 121 from the above, which sufficiently ensures the heat dissipation performance of the vertical-cavity surface-emitting laser.

In other embodiments, as shown in FIG. 4, an orthographic projection of an edge of the electrically conductive heat-spreading layer 122b away from the light-emitting aperture 121a on the substrate is located within the orthographic projection of the confinement trench 121f on the substrate. That is, the projection of the electrically conductive heat-spreading layer 122b along the vertical direction is partially overlapped with the projection of the confinement trench 121f along the vertical direction, which not only satisfies the heat dissipation performance of the vertical-cavity surface-emitting laser, but also allows a flexible structural design of the vertical-cavity surface-emitting laser.

It should be noted that on the premise of satisfying the heat dissipation performance of the vertical-cavity surface-emitting laser, the orthographic projection of the electrically conductive heat-spreading layer 122b on the substrate does not coincide with the orthographic projection of the confinement trench 121f on the substrate. That is, the orthographic projection of the electrically conductive heat-spreading layer 122b on the substrate is located within the orthographic projection of the confinement trench 121f on the substrate, which can be selected according to actual conditions.

In some embodiments, the laser emitting structure 121 is provided with a plurality of the light-emitting apertures 121a, and two adjacent light-emitting apertures 121a share a confinement trench 121f adjacent thereto, which allows a plurality of light-emitting apertures 121a to be arranged within a limited area, thereby realizing the fabrication of the vertical-cavity surface-emitting laser array 100 with a higher bandwidth density, and facilitating a higher output power density.

Exemplarily, the first electrode 122a is configured to provide an electric current path to inject electric current into the active layer 121c in the region of the light-emitting aperture 121a, and the first electrode 122a can form an ohmic contact to reduce the contact resistance of the device. In the present embodiment, the first electrode 122a is a P-type ohmic metal, and the first electrode 122a also contributes to heat conduction, thereby maintaining the operation temperature of the device. The material of the first electrode 122a includes at least one of gold, copper, silver, tin, or indium. The thickness of the first electrode 122a is in a range from 0.1 µm to 0.5 µm. In the present embodiment, the thickness of the first electrode 122a is 0.3 µm, and the first electrode 122a is a P-type ohmic metal.

Exemplarily, the electrically conductive heat-spreading layer 122b covers the first electrode 122a, and the orthographic projection of the light-emitting aperture 121a on the substrate 11 is located within the orthographic projection of the electrically conductive heat-spreading layer 122b on the substrate 11, which can effectively reduce the volume of the laser 1, enabling the fabrication of the device with a high bandwidth density. In addition, during the operation of the laser emitting structure 121, the heat dissipation requirement can be fully met, thereby effectively improving the heat dissipation performance of the laser 1. The material of the electrically conductive heat-spreading layer 122b includes at least one of gold, copper, silver, tin, indium, or other suitable materials.

In some embodiments, as shown in FIGS. 1 and 2, the laser emitting structure 121 further includes an insulating layer 121g. The insulating layer 121g is filled in the confinement trench 121f. The material of the insulating layer 121g includes an organic material, such as a high-molecular polymer or benzocyclobutene (BCB), or an electrolyte inorganic material, such as silicon nitride or silicon oxide. The insulating layer 121g filled in the confinement trench 121f can restrict the lateral spreading of the optical field, improve the efficiency of concentrated electric current injection into the region of the light-emitting aperture 121a, reduce parasitic current loss, and improve laser beam quality, and can avoid electric field interference and current leakage, thereby improving the stability of electrical performance. Moreover, the insulating layer 121g can also provide support for the connection structure 122, so as to enhance the mechanical stability and processing reliability of the device, and relieve the thermal stress of the laser 1 during operation.

In addition, the electrically conductive heat-spreading layer 122b is located above the insulating layer 121g, and a plurality of isolation layers 14 are provided between the electrically conductive heat-spreading layer 122b and the insulating layer 121g. The material of the isolation layer 14 includes silicon nitride, preventing a direct contact between the electrically conductive heat-spreading layer 122b and the insulating layer 121g, which otherwise affects the performance of the laser emitting structure 121. Further, the plurality of isolation layers 14 act together with the insulating layer 121g to further provide support for the electrically conductive heat-spreading layer 122b, thereby alleviating the thermal stress issue during the operation of the laser 1.

In some embodiments, as shown in FIGS. 1 to 3, the laser emitting structure 121 further includes an ion implantation region 121h. The ion implantation region 121h is located in an upper surface layer of the second reflective layer 121d, and the ion implantation region 121h surrounds the light-emitting aperture 121a. The depth of the ion implantation region 121h is usually designed to be slightly less than or close to a total thickness of the second reflective layer 121d, so as to ensure electric current confinement and optical waveguide effects. The implanted ions include hydrogen ions, oxygen ions, helium ions, boron ions, or other suitable implanted ions. The distance between the ion implantation region 121h and the light-emitting aperture 121a is greater than 1 µm. In the present embodiment, the ion implantation region 121h also surrounds the confinement trench 121f, and the ion implantation region 121h acts together with the confinement layer 121e to provide additional electric current and optical mode confinements in the lateral direction.

In some other embodiments, as shown in FIG. 3, the electrically conductive heat-spreading layer 122b is further filled in the confinement trench 121f. By filing the electrically conductive heat-spreading layer 122b into the confinement trench 121f, the support stability of the electrically conductive heat-spreading layer 122b can be ensured, and the heat dissipation performance of the electrically conductive heat-spreading layer 122b can be further improved. In this case, a plurality of isolation layers 14 are provided between the active layer 121c at the bottom of the confinement trench 121f and the electrically conductive heat-spreading layer 122b. The material of the isolation layers 14 includes silicon nitride, preventing a direct contact between the electrically conductive heat-spreading layer 122b and the active layer 121c, which otherwise affects the performance of the laser emitting structure. Moreover, the plurality of isolation layers 14 also provide support for the electrically conductive heat-spreading layer 122b, thereby alleviating the thermal stress issue during the operation of the vertical-cavity surface-emitting laser.

In some embodiments, as shown in FIGS. 1 to 3, the connection structure 122 further includes a first electrically conductive pillar 122c. The first electrically conductive pillar 122c is located on an upper surface of the electrically conductive heat-spreading layer 122b. The first electrically conductive pillar 122c can be used as a lead-out electrode. The material of the first electrically conductive pillar 122c includes at least one of gold, copper, silver, tin, indium, or other suitable materials. In the present embodiment, the material of the first electrically conductive pillar 122c includes copper. The first electrically conductive pillar 122c acts as an anode to receive an input current. The thickness of the first electrically conductive pillar 122c is in a range from 25 µm to 35 µm, and the width of the first electrically conductive pillar 122c is in a range from 35 µm to 50 µm. In the present embodiment, the thickness of the first electrically conductive pillar 122c is 30 µm, and the width of the first electrically conductive pillar 122c is 40 µm.

A first soldering layer 122d is further provided on an upper surface of the first electrically conductive pillar 122c. The first soldering layer 122d is configured for electrical and mechanical connection in the subsequently packaged structure. The material of the first soldering layer 122d includes at least one of silver or tin. The thickness of the first soldering layer 122d is in a range from 10 µm to 15 µm. In the present embodiment, the thickness of the first soldering layer 122d is 12 µm, and the material of the first soldering layer 122d is silver tin.

In some embodiments, as shown in FIGS. 1 to 3, the laser 1 further includes at least one second unit 13. The second unit 13 is located on an upper surface of the substrate 11. The second unit 13 is electrically connected to the first unit 12. The second unit 13 at least includes a second electrode 131 and a second electrically conductive pillar 132. An upper surface of the second electrically conductive pillar 132 is flush with the upper surface of the first electrically conductive pillar 122c.

Exemplarily, the second electrode 131 is configured to provide an electric current path to form a complete electrical connection path, thereby enabling normal operation of the laser 1. In the present embodiment, the second electrode 131 is an N-type ohmic metal. The material of the second electrode 131 includes at least one of gold, copper, silver, tin, or indium. The thickness of the second electrode 131 is in a range from 1 µm to 5 µm. In the present embodiment, the thickness of the second electrode 131 is 2 µm.

Exemplarily, the second electrically conductive pillar 132 acts as a lead-out electrode, which facilitates the subsequent packaging of the laser 1. The material of the second electrically conductive pillar 132 includes gold, copper, silver, tin, indium, or other suitable materials. In the present embodiment, the material of the second electrically conductive pillar 132 includes copper. The second electrically conductive pillar 132 acts as a cathode to output electric current. The thickness of the second electrically conductive pillar 132 is in a range from 25 µm to 35 µm, and the width of the second electrically conductive pillar 132 is in a range from 35 µm to 50 µm. In the present embodiment, the thickness of the second electrically conductive pillar 132 is 30 µm, and the width of the second electrically conductive pillar 132 is 40 µm.

A second soldering layer 134 is further provided on the upper surface of the second electrically conductive pillar 132. The second soldering layer 134 is configured for electrical and mechanical connection in the subsequently packaged structure. The material of the second soldering layer 134 includes at least one of silver or tin. The thickness of the second soldering layer 134 is in a range from 10 µm to 15 µm. In the present embodiment, the thickness of the second soldering layer 134 is 12 µm, and the material of the second soldering layer 134 is silver tin.

The upper surface of the second electrically conductive pillar 132 is arranged to be flush with the upper surface of the first electrically conductive pillar 122c, and the upper surface of the first unit 12 is arranged to be flush with the upper surface of the second unit 13, so that packaging can be performed directly during the subsequent packaging process, without the need for a complex lead-out electrode structure design, thereby providing a higher design freedom for the multi-channel light-emitting array, enabling more convenient integration of the array and connection of the driving circuit, and realizing more compact optical communication modules and consumer electronic product designs with improved bandwidth density.

In some embodiments, the second unit 13 further includes an electrically conductive pad 133. The electrically conductive pad 133 is located between the second electrically conductive pillar 132 and the second electrode 131. The electrically conductive pad 133 serves as an intermediate layer, such that the upper surface of the second unit 13 is flush with the upper surface of the first unit 12. Exemplarily, the electrically conductive pad 133 includes a first pad portion 133a and a second pad portion 133b, and the second pad portion 133b and the electrically conductive heat-spreading layer 122b are disposed in a same plane. The material of the first pad portion 133a includes at least one of gold, copper, silver, tin, indium, or other suitable materials. The thickness of the first pad portion 133a is in a range from 7 µm to 10 µm. In the present embodiment, the thickness of the first pad portion 133a is 8 µm. The material of the second pad portion 133b includes at least one of gold, copper, silver, tin, indium, or other suitable materials. The thickness of the second pad portion 133b is in a range from 3 µm to 6 µm. In the present embodiment, the thickness of the second pad portion 133b is 5 µm.

The laser 1 can further include a contact layer 15. The contact layer 15 is located above the substrate 11. The first unit 12 and the second unit 13 are electrically connected to each other through the contact layer 15.

In some embodiments, as shown in FIGS. 1 and 2, the contact layer 15 is located on an upper surface of the substrate 11, and an upper surface of the contact layer 15 is in contact with the first reflective layer 121b and the second electrode 131. By forming the contact layer 15 on the surface of the substrate 11, interference of the contact layer 15 with the optical cavity mode during laser emission from a lower surface of the substrate 11 can be avoided. Besides, the contact layer 15 is in direct contact with the second electrode 131, thereby realizing the ohmic contact with the second electrode 131 and reducing the contact resistance of the device. The material of the contact layer 15 includes gallium arsenide, indium phosphide, a transparent conductive oxide, or other suitable materials. The size and shape of the contact layer 15 can be selected according to actual conditions as long as the performance of the vertical-cavity surface-emitting laser is satisfied, and are not limited herein.

In some other embodiments, as shown in FIG. 3, the contact layer 15 is located on an upper surface of the first reflective layer 121b, the first reflective layer 121b is located on the upper surface of the substrate 11, and the upper surface of the contact layer 15 is in contact with the active layer 121c and the second electrode 131. By forming the contact layer 15 on the upper surface of the first reflective layer 121b, electric current injection is directly applied to the active region adjacent to the contact layer 15, resulting in a short current path and reducing current conduction loss, which is suitable for high-speed modulation and high-power designs.

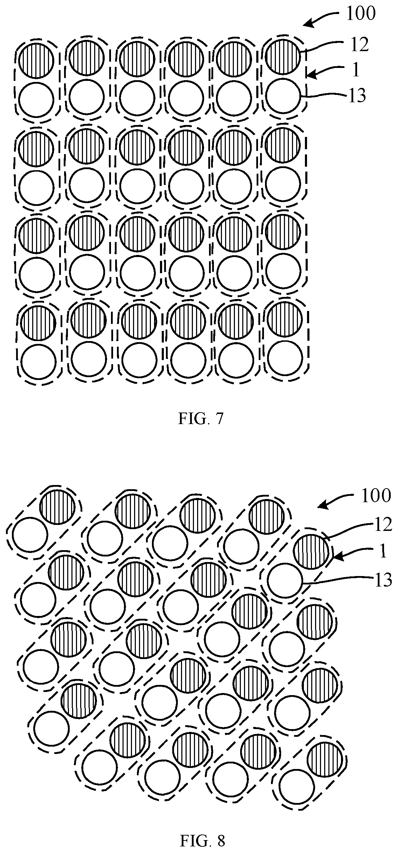

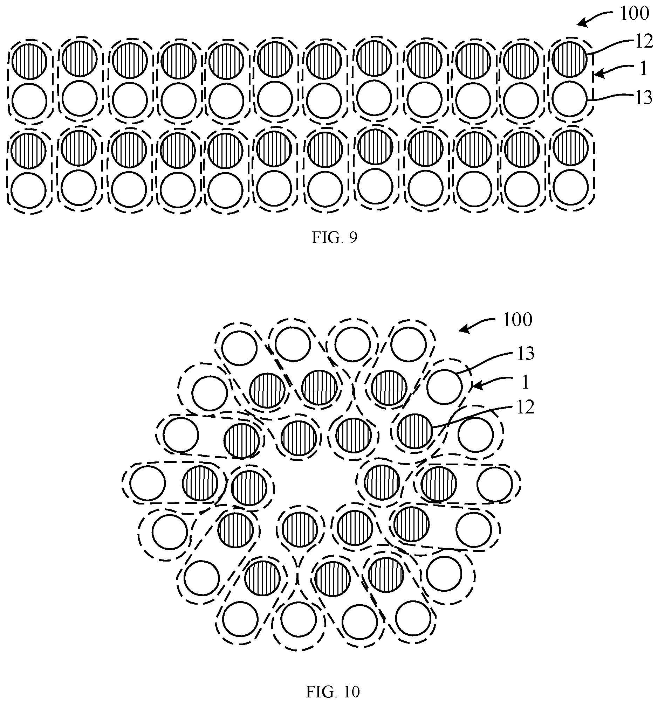

In some embodiments, as shown in FIGS. 7 to 12, the vertical-cavity surface-emitting laser array 100 includes a plurality of lasers 1. The plurality of lasers 1 can be manufactured to be electrically insulated from each other, so as to realize various flexible arrangement layouts of the lasers 1. The plurality of lasers 1 can be arranged within a limited area, realizing the fabrication of the vertical-cavity surface-emitting laser array 100 with a higher bandwidth density, which is conducive to a higher output power density.

In addition, in some embodiments, the first units 12 in the plurality of lasers 1 share the connection structure 122, and the first units 12 in the plurality of lasers 1 share the second unit 13.

In some other embodiments, the first units 12 in the plurality of lasers 1 share the connection structure 122, or the first units 12 in the plurality of lasers 1 share the second unit 13. That is, the first units 12 in the plurality of lasers 1 share the anode, and the first units 12 in the plurality of lasers 1 share the second unit 13; or the first units 12 in the plurality of lasers 1 share the anode, or the first units 12 in the plurality of lasers 1 share the second unit 13, thereby improving the light emission efficiency and system-level anti-interference capability of the vertical-cavity surface-emitting laser array 100.

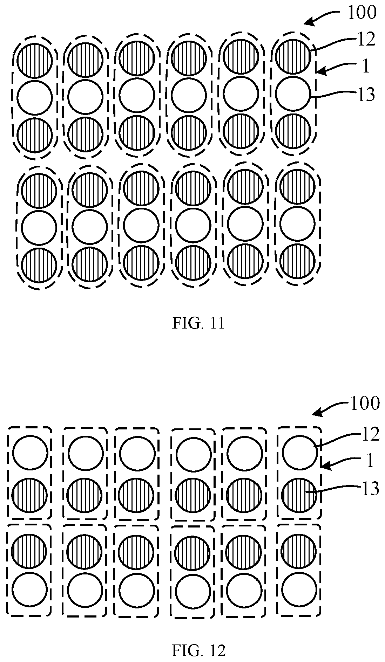

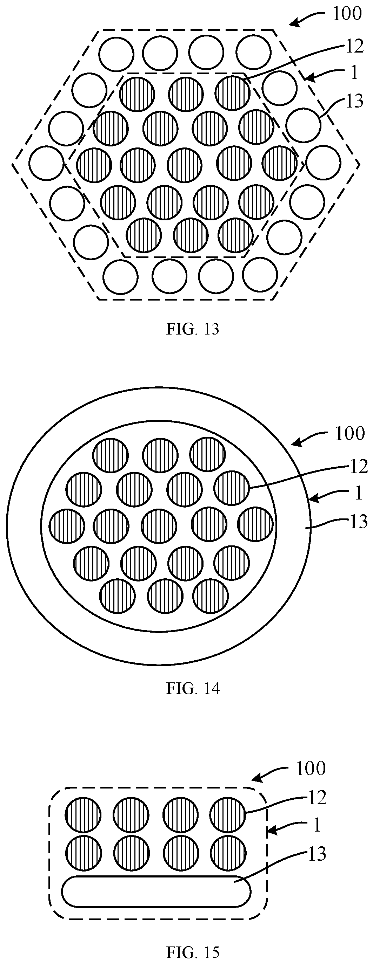

In some embodiments, as shown in FIGS. 12 to 15, the laser 1 includes a plurality of first units 12, the plurality of first units 12 share the second unit 13, and the plurality of first units 12 share the connection structure 122.

In some other embodiments, the laser 1 includes a plurality of first units 12, and the plurality of first units 12 share the second unit 13, or the plurality of first units 12 share the connection structure 122. The laser 1 is arranged to include the plurality of first units 12, which is conducive to the fabrication of the vertical-cavity surface-emitting laser array 100 with a higher bandwidth density, and improving the output power density. In addition, the structure of the laser 1 can be flexibly designed to meet different needs. For example, the laser 1 can include a plurality of first units 12, and the plurality of first units 12 share the second unit 13, that is, when the second unit 13 acts as a cathode terminal, the plurality of first units 12 share the cathode. The laser 1 can include a plurality of first units 12, and the plurality of first units 12 share the connection structure 122, that is, when the first unit 12 acts as an anode terminal, the plurality of first units 12 share the anode. The configuration of sharing anode or cathode can provide the laser 1 with better light-emission efficiency and system-level anti-interference capability. The second unit 13 can be a common unit, or a plurality of second units 13 can also be provided. Meanwhile, the first unit 12 and the second unit 13 are electrically connected to each other to ensure a complete current operation path.

In some embodiments, a lens, a grating, or a metasurface structure are further integrated on the lower surface of the substrate 11 of the first unit 12, which can further focus the laser beam emitted by the laser emitting structure 121, thereby effectively improving laser beam quality and application effects. Moreover, the metasurface structure can also generate specific laser beam patterns, playing important roles in applications such as optical manipulation and communication.

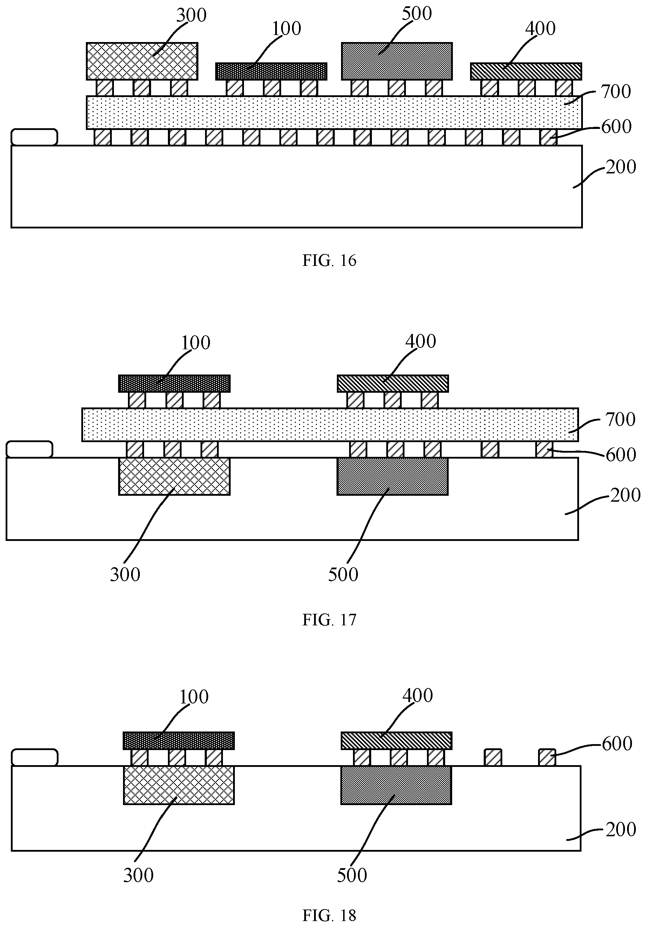

Continuing to refer to FIGS. 16 to 18, the present disclosure also provides an integrated system of chips, including the vertical-cavity surface-emitting laser array 100 described above and a base board 200, wherein the vertical-cavity surface-emitting laser array 100 is mounted on the base board 200 and is electrically connected to the base board 200.

In some embodiments, the integrated system further includes a driving structure 300, a signal conversion structure 400, and a signal amplification structure 500. The driving structure 300, the signal amplification structure 500, and the signal conversion structure 400 are all electrically connected to the base board 200. The driving structure 300 provides sufficient driving current and driving voltage for the vertical-cavity surface-emitting laser array 100 to ensure the normal operation of the vertical-cavity surface-emitting laser array 100. The signal conversion structure 400 is configured to convert optical signals emitted by the vertical-cavity surface-emitting laser array 100 into electrical signals. The signal amplification structure 500 is configured to amplify the electrical signals.

In the packaging of the above-mentioned integrated system, the electrodes of the lasers 1 in the vertical-cavity surface-emitting laser array 100 are located on the same side, by which the vertical-cavity surface-emitting laser array 100 is more readily directly interfaced with the base board 200, improving the reliability of electrical connections, and better conforming to the needs of planar design, thereby reducing the number of packaging leads and complexity thereof, simplifying chip-level and system-level packaging processes, and reducing stress concentration and damage risks during packaging.

In some embodiments, as shown in FIG. 16, the integrated system of chips further includes an interposer 700. The vertical-cavity surface-emitting laser array 100, the driving structure 300, the signal amplification structure 500, and the signal conversion structure 400 are all electrically connected to the interposer 700 through solder pins 600, and the interposer 700 is electrically connected to the base board 200 through solder pins 600. The base board 200 includes an integrated circuit substrate.

In some other embodiments, as shown in FIG. 17, the integrated system of chips includes an interposer 700. The vertical-cavity surface-emitting laser array 100 and the signal amplification structure 500 are electrically connected to an upper surface of the interposer 700 through solder pins 600. The driving structure 300 and the signal conversion structure 400 are electrically connected to a lower surface of the interposer 700 through the solder pins 600. Moreover, the driving structure 300 and the signal conversion structure 400 are integrated with the base board 200, and the base board 200 includes a computing chip.

In a third embodiment, as shown in FIG. 18, the lower side of the vertical-cavity surface-emitting laser array 100 is electrically connected to the driving structure 300 through solder pins 600, and the lower side of the signal amplification structure 500 is electrically connected to the signal conversion structure 400 through solder pins 600. The driving structure 300 and the signal conversion structure 400 are integrated with the base board 200, and the base board 200 includes a computing chip.

In the description of the present specification, reference to terms such as "some embodiments", "other embodiments", "an ideal embodiment", etc., means that a particular feature, structure, material, or characteristic described in connection with the embodiment or example is included in at least one embodiment or example of the present disclosure. The illustrative descriptions of the above terms in the present specification are not necessarily referring to the same embodiment or example.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present disclosure.

The above-described embodiments are only several implementations of the present disclosure, and the descriptions are relatively specific and detailed, but they should not be construed as limiting the scope of the present disclosure. It should be understood by those of ordinary skill in the art that various modifications and improvements can be made without departing from the concept of the present disclosure, and all fall within the protection scope of the present disclosure. Therefore, the patent protection of the present disclosure shall be defined by the appended claims.

## Claims

1. A vertical-cavity surface-emitting laser array, comprising:
at least one laser, the laser comprising a substrate and at least one first unit located on the substrate; wherein the first unit comprises a laser emitting structure and a connection structure located above the laser emitting structure; the laser emitting structure is provided with at least one light-emitting aperture; the connection structure at least comprises a first electrode and an electrically conductive heat-spreading layer, which are sequentially stacked;
the first electrode is disposed opposite to the light-emitting aperture; the electrically conductive heat-spreading layer covers the first electrode; and an orthographic projection of the light-emitting aperture on the substrate is located within an orthographic projection of the electrically conductive heat-spreading layer on the substrate.

2. The vertical-cavity surface-emitting laser array according to claim 1, wherein the laser emitting structure comprises a confinement layer and a confinement trench extending through the confinement layer, and the confinement trench surrounds the light-emitting aperture; an orthographic projection of the confinement trench on the substrate is at least partially located within the orthographic projection of the electrically conductive heat-spreading layer on the substrate.

3. The vertical-cavity surface-emitting laser array according to claim 2, wherein the laser emitting structure further comprises an insulating layer, and the insulating layer is filled in the confinement trench.

4. The vertical-cavity surface-emitting laser array according to claim 2, wherein the conductive heat-spreading layer is further filled in the confinement trench.

5. The vertical-cavity surface-emitting laser array according to claim 2, wherein the laser emitting structure is provided with a plurality of the light-emitting apertures, and two adjacent light-emitting apertures share a confinement trench adjacent to the two adjacent light-emitting apertures.

6. The vertical-cavity surface-emitting laser array according to claim 2, wherein the confinement trench surrounding the light-emitting aperture includes a plurality of trenches spaced from each other.

7. The vertical-cavity surface-emitting laser array according to claim 2, wherein the confinement trench surrounding the light-emitting aperture includes an annular trench.

8. The vertical-cavity surface-emitting laser array according to claim 1, wherein the connection structure further comprises a first electrically conductive pillar, and the first electrically conductive pillar is located on an upper surface of the electrically conductive heat-spreading layer.

9. The vertical-cavity surface-emitting laser array according to claim 8, wherein the laser further comprises at least one second unit; the second unit is located on an upper surface of the substrate and is electrically connected to the first unit; the second unit at least comprises a second electrode and a second electrically conductive pillar, and an upper surface of the second electrically conductive pillar is flush with an upper surface of the first electrically conductive pillar.

10. The vertical-cavity surface-emitting laser array according to claim 9, wherein the second unit further comprises an electrically conductive pad, and the electrically conductive pad is located between the second electrically conductive pillar and the second electrode.

11. The vertical-cavity surface-emitting laser array according to claim 10, wherein the electrically conductive pad comprises a first pad portion and a second pad portion, and the second pad portion and the electrically conductive heat-spreading layer are disposed in a same plane.

12. The vertical-cavity surface-emitting laser array according to claim 9, wherein the laser comprises a plurality of the first units; the plurality of the first units share the second unit, and the plurality of the first units share the connection structure.

13. The vertical-cavity surface-emitting laser array according to claim 9, wherein the laser comprises a plurality of the first units; the plurality of the first units share the second unit, or the plurality of the first units share the connection structure.

14. The vertical-cavity surface-emitting laser array according to claim 9, comprising a plurality of the lasers, wherein the first units in the plurality of lasers share the connection structure, and the first units in the plurality of lasers share the second unit.

15. The vertical-cavity surface-emitting laser array according to claim 9, comprising a plurality of the lasers, wherein the first units in the plurality of lasers share the connection structure, or the first units in the plurality of lasers share the second unit.

16. The vertical-cavity surface-emitting laser array according to claim 1, wherein the laser emitting structure further comprises a first reflective layer, an active layer and a second reflective layer, and the light-emitting aperture is located between the second reflective layer and the active layer.

17. An integrated system, comprising the vertical-cavity surface-emitting laser array according to any one of claims 1 to 16, and a base board, wherein the vertical-cavity surface-emitting laser array is mounted on the base board and is electrically connected to the base board.

18. The integrated system according to claim 17 further comprising a driving structure, a signal conversion structure and a signal amplification structure, wherein the driving structure, the signal amplification structure, and the signal conversion structure are all electrically connected to the base board.
